(19) Europäisches Patentamt
European Patent Office
Office européen des brevets

(11) **EP 2 760 093 B1**

(12) **EUROPEAN PATENT SPECIFICATION**

(45) Date of publication and mention
of the grant of the patent:
**12.04.2017 Bulletin 2017/15**

(51) Int Cl.:
*H02H 3/00* *(2006.01)*      *H02H 3/38* *(2006.01)*
*H02H 5/04* *(2006.01)*

(21) Application number: **13153042.0**

(22) Date of filing: **29.01.2013**

(54) **Power switch fault detection system**

Netzschalter-Fehlerdetektionssystem

Système de détection de défaut d'interrupteur de puissance

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**30.07.2014 Bulletin 2014/31**

(73) Proprietor: **Delphi Technologies, Inc.
Troy, MI 48007 (US)**

(72) Inventors:
• **Bonne, François
92600 Asnières-sur-Seine (FR)**
• **Deroubaix, Nicolas
93800 Epinay-sur-Seine (FR)**

(74) Representative: **Delphi France SAS
Patent Department
22, avenue des Nations
CS 65059 Villepinte
95972 Roissy CDG Cedex (FR)**

(56) References cited:
**US-A- 4 896 245**      **US-A- 5 570 259**
**US-A1- 2005 088 863**      **US-A1- 2005 237 689**
**US-B2- 7 113 019**

**Description**

Technical Field

This disclosure relates generally to detecting faults in semiconductor devices, and has particular, but non-exclusive application to semiconductor devices used to switch high current loads. It further has particular application to the use of semiconductor devices in harsh environments, such as automotive environments, but it is not limited to such use.

Background of the Invention

Nowadays, engine management systems for vehicles, and the Electronic Control Units (ECUs) used in such systems, utilise semiconductor devices such as switches and drivers to control and drive loads and actuators. These are often referred to as "Smartpower" switches. Such devices need to be robust and adapted for use in harsh (e.g. automotive) environments, so as to switch high levels of current safely and reliably. In addition, these devices need to provide protection and safety in the event of a fault occurring on the drive/actuator output. Most of such switches include an over-temperature shutdown in case of the silicon temperature exceeds the maximum junction temperature. This over-temperature event might be caused by a variety of reasons, commonly system faults like overload. Such faults are, for example, commonly caused by short circuits to ground, or overload situations. There is a need to improve the robustness and reliability of such devices when operating in vehicle ECUs, both in normal use, as well as in any fault mode. Electronic Control Units in engine management systems need to cater for a wide range of vehicles. Furthermore, there is a need in such units to reduce the risk of electrical faults occurring in switching and drive devices. Aspects of the invention are however not restricted to automotive applications, and are applicable to semiconductor switches, power devices and drivers in general.

It is an object to provide a method and system which can give a predictive/actual indication or other diagnosis reflecting the condition of the device in real time. It is thus an object to increase the robustness of the device by appropriate monitoring it. Furthermore, it is desirable that any instantaneous or slowly developing faults are detected and dealt with appropriately.

US Patent Application No. 4896245 describes a method to switch of a FET at excessive temperatures. US Patent Application Publication US 2005/088863 describes a method to map temperature with voltage and current values of a buck converter.US Patent 7113019 describes a method of sensing the temperature of a power device. US 2005/0237689 describes a switch-off threshold of an electronic component for protection from temperature specific overload.

Summary of the Invention

In one aspect of the invention is provided a method of monitoring a semiconductor device which includes a transistor, comprising determining the resistance $R_{dson}$ between the drain and the source of the transistor when the device is in an operative state, and comparing this against an expected value, $R_{dsonexp}$ and determining that there is a fault as a result of said comparison.

Preferably the method includes the steps of determining the drain-source current, $I_{ds}$, flowing through the device transistor, and determining the differential drain-source voltage $V_{ds}$ across the transistor.

Preferably the value of $R_{dson}$ is determined by the equation

$$R_{dson} = V_{ds}/I_{ds}$$

Preferably the temperature $T_{real}$ of the device is measured or estimated and used to determine a value of the expected value $R_{dsonexp}$.

The expected value $R_{dsonexp}$ may be determined by the equation: $R_{dsonexp} = R_{dsonTx} (1 + \alpha (T_{real}-T_x))$ where $R_{dsonTx}$ is the value of the resistance of the power device at a temperature $T_x$ and $T_{real}$ is the temperature of the device.

$T_x$ may be the ambient temperature between 15 and 35° C.

The method may include determining the difference between the actual resistance $R_{dson}$ and the expected resistance $R_{dsonexp}$ as a proportion of the expected resistance, and determining there is a fault is this proportion exceeds or equals a threshold value.

If it is determined there is a fault, an alert may be generated or said device switched off.

The semiconductor device may be part of a vehicle management system or vehicle electronic control unit. The device may be a switching device, power device, driver device, or Smartpower device. The transistor may be a MOSFET or other power transistor.

Also provided is system adapted to monitor a semiconductor device which includes a transistor, comprising means to determining the resistance $R_{dson}$ between the drain and the source of the transistor when the device is in an operative state, and means to compare this value against an expected value , $R_{dsonexp}$ to determine if there is a fault.

One of the main faults which can occur within a vehicle ECU is electro-migration, which can arise when long-term short circuit or current leakage occurs. This phenomenon is related to the transport of metal atoms at the metallization level in semiconductor devices. High current density encourages electro-migration.

Such devices typically include a transistor such as a power transistor, usually a MOSFET having gate, drain and source terminals. Tests performed by the inventors have shown that that electro-migration causes an increase in the value of $R_{dson}$, that is, the resistance between drain and source of a transistor of a semiconductor device when in an "on" state.

In an aspect of the invention, the value of $R_{dson}$, and the drift in this value, is monitored. This allows an assessment of the fatigue state and of the extent of electro-migration within the semiconductor device to be determined by monitoring for any immediate or insipid (slowly occurring) fault occurring in the device.

The monitored value of $R_{dson}$ may be compared to an expected value $R_{dsonexp}$. In operation, if there is an unreasonable discrepancy between the actual and the expected value, it may be assumed that a fault has developed. In the event, an alert may be generated; alternatively the device may be switched off.

Brief Description of the Drawings

The present invention will now be described, by way of example, with reference to the accompanying drawings, in which:

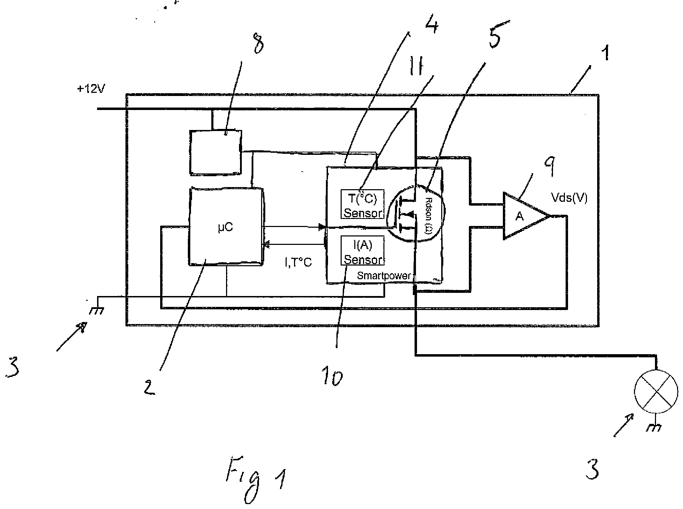

Figure 1 shows a schematic circuit diagram of an Electronic Control Unit incorporating an example of the invention.

Description of the Preferred Embodiments

Fig. 1 is a schematic circuit diagram of an Electronic Control Unit 1 for a vehicle. This includes a microcontroller 2 whose function is to process data and provide an output to one or more drives, loads or actuators 3. The microcontroller is connected to a power device 4 such as a Smartpower device which includes a transistor 5 such as a power transistor e.g. a MOSFET. The power transistor includes three terminals source, drain and gate. The microcontroller and power device are connected to a power supply block 8 which provides both with a source of power. An amplifier 9 is provided which is an additional block and is a measurement amplifier that is used to measure the differential voltage across the drain and source terminals of the 'Smartpower" device. The amplifier input impedance is of high impedance (a few MOhm)

The power device includes means 10 to measure the drain-source current that flows through the transistor. In a preferred example, such as that shown in the figure, the device also includes temperature measurement means 11 to measure the temperature of the device.

According to an example, a method determines the value of $R_{dson}$, that is the resistance between the drain and the source of the device transistor when it is in an "on" state. This is determined in one example by measuring the following two variables:

i) $I_{ds}$, that is, the drain-source current that flows in the device transistor. This can be measured by the use of a measurement block integrated within the device.
ii) $V_{ds}$, that is, the drain to source voltage.

$V_{ds}$ can be determined from the use of a measurement block (e.g. amplifier 9) located within the ECU to measure the differential across the power transistor of the (e.g. Smartpower) device driver. As the power MOSFET is integrated within the (Smartpower) device, one way to measure the drain-source voltage of the transistor is to measure the voltage across the (Smartpower) device package pins (drain pin, source pin). The drain and source terminals of the MOSFETs are typically connected to the (Smartpower) device pins by the use of bonding (the transistor drain is soldered on the device leadframe and the transistor source is connected to the device (Smarpower) pin by the use of wire/leadframe bonding.

The value of $R_{dson}$ can be determined by the equation $V_{ds}/I_{ds}$. This value is then compared with an expected value $R_{dsonexp}$, to detect if there is a fault developing, or has developed, in the device. This value ($R_{dsonexp}$) can be stored in the system.

It would be clear to the skilled reader that there may be a variety of different ways in which a developing fault may be assumed to exist. If there is a large enough discrepancy between $R_{dson}$ and $R_{dsonexp}$, one can assume that a fault has developed. One particular way of doing this is to see how much proportionally $R_{dson}$ has altered (e.g. increased) from $R_{dsonexp}$. Thus, in an example, the following equation may be used to determine if a fault needs to be flagged:

$$\% \text{ increase in discrepancy} = (R_{dson} - R_{dsonexp})/ R_{dsonexp},$$

If this increase is greater than a threshold, which may be stored, a fault may be assumed.

In a preferred example, the temperature of the device is also taken into account. Even without any fault, the value of $R_{dson}$ will change with device temperature. In a preferred example, the value of $T_{real}$, the device temperature is measured buy a suitable temperature measurement block located with the device, i.e. integrated within it. The measured (or estimated temperature) is then used to adjust the expected value $R_{dsonexp}$, to which $R_{dson}$ is compared.

In one example, expected value of $R_{dsonexp}$ is adjusted according to the following equation:

$$R_{dsonexp} = R_{dson25} \ (1 + \alpha \ (T_{real}-25))$$

where $R_{dson25}$ is the value of the resistance between drain and source of the device transistor at a temperature of 25°C, and a is some constant.

Of course it is to be understood that not just 25°C, but any suitable ambient temperature may be used for this purpose, and the equation amended correspondingly.

The value $R_{dson25}$ can be determined during an initial calibration process, for example during a final test step during assembly. This value can be stored as a reference value within the ECU.

The above description is considered that of the preferred embodiments only. Modifications of the invention will occur to those skilled in the art and to those who make or use the invention. Therefore, it is understood that the embodiments shown in the drawings and described above are merely for illustrative purposes and not intended to limit the scope of the invention, which is defined by the following claims as interpreted according to the principles of patent law, including the doctrine of equivalents.

## Claims

1.   A method of monitoring a semiconductor device (4) which includes a transistor (5) as part of a power device, comprising determining the resistance $R_{dson}$ between the drain and the source of the transistor (5) when the transistor (5) is in an ON state, and comparing this against an expected value, $R_{dsonexp}$ and determining that there is a fault as a result of said comparison, characterised wherein the temperature $T_{real}$ of the device is measured or estimated and used to determine a value of the expected value $R_{dsonexp}$.

2.   A method as claimed in claim 1 including the steps of determining the drain-source current, $I_{ds}$, flowing through the transistor (5), and determining the differential drain-source voltage $V_{ds}$ across the transistor.

3.   A method as claimed in claim 2 wherein the value of $R_{dson}$ is determined by the equation

$$R_{dson} = V_{ds}/I_{ds}$$

4.   A method as claimed in claim 1 wherein said expected value $R_{dsonexp}$ is determined by the equation:

$$R_{dsonexp} = R_{dsonTx} \ (1 + \alpha \ (T_{real}-T_x))$$

where $R_{dsonTx}$ is the value of the resistance of the power device (5) at a temperature $T_x$ and $T_{real}$ is the temperature of the device.

5.   A method as claimed in claim 4 wherein $T_x$ is an ambient temperature between 15 and 35° C.

6.   A method as claimed in any preceding claim including determining the difference between the actual resistance $R_{dson}$ and the expected resistance $R_{dsonexp}$ as a proportion of the expected resistance, and determining there is a fault is this proportion exceeds or equals a threshold value.

**7.** A method as claimed in claims 1 to 6 including, if it is determined there is a fault, generating an alert or switching off said device.

**8.** A method as claimed in claims 1 to 7 wherein said semiconductor device (4) is part of a vehicle management system or vehicle electronic control unit (1).

**9.** A method as claimed in claim 1 to 8 wherein said device (4) is a switching device, power device, driver device, or Smartpower device.

**10.** A method as claimed in claims 1 to 9 wherein said transistor (5) is a MOSFET or other power transistor.

**11.** A system adapted to monitor a semiconductor device (4)which includes a transistor (5)as part of a power device, comprising means to determining the resistance $R_{dson}$ between the drain and the source of the transistor when the transistor in an ON state, and means to compare this value against an expected value , $R_{dsonexp}$ to determine if there is a fault and **characterised in** having means (11) to estimate or measure the temperature $T_{real}$ of the device and use this to determine an expected value $R_{dsonexp}$

**12.** A system as claimed in claim 11 including the means (10) to determine the drain-source current, $I_{ds}$, flowing through the transistor, and the differential drain-source voltage, $V_{ds}$ across the transistor.

**13.** A system as claimed in claims 11 or 12 having means to determine the value of $R_{dson}$ from the equation $R_{dson} = V_{ds}/I_{ds}$

**14.** A system as claimed in claim 11 having means to determine said expected value from the equation:

$$R_{dsonexp} = R_{dsonTx} \; (1 + \alpha \, (T_{real} - T_x))$$

where $R_{dsonTx}$ is the value of the resistance of the device (4) at a set temperature $T_x$ and $T_{real}$ is the measured temperature of the device.

**15.** A system as claimed in claim 14 wherein $T_x$ is an ambient temperature between 15 and 35° C.

**16.** A system as claimed in claims 11 to 15 including means to determining the difference between the actual resistance $R_{dson}$ and the expected resistance $R_{dsonexp}$ as a proportion of the expected resistance, and means to determine there is a fault is this proportion exceeds or equals a threshold value.

**17.** A system as claimed in claims 11 to 16 having means to generate an alert or switch off said device, if it is determined that there is a fault.

**18.** A system as claimed in claims 11 to 17 wherein semiconductor device (4) is part of a vehicle management system or vehicle electronic control unit.

**19.** A system as claimed in any of claims 11 to 18 wherein said device (4) is a switching device, power device, driver device, or Smartpower device.

**20.** A system as claimed any of claims 11 to 19 transistor (5) is a MOSFET or other power transistor.

**Patentansprüche**

**1.** Verfahren zum Überwachen einer Halbleitervorrichtung (4), die einen Transistor (5) umfasst als Teil einer Leistungsvorrichtung, das aufweist ein Bestimmen des Widerstands $R_{dson}$ zwischen dem Drain und der Source des Transistors (5), wenn der Transistor (5) in einem EIN-Zustand ist, und Vergleichen dieses mit einem erwarteten Wert, $R_{dsonexp}$, und Bestimmen, dass es einen Fehler gibt, als Ergebnis des Vergleichs, **dadurch gekennzeichnet, dass** die Temperatur $T_{real}$ der Vorrichtung gemessen oder geschätzt wird und zum Bestimmen eines Werts des erwarteten Werts $R_{dsonexp}$ verwendet wird.

**2.** Ein Verfahren gemäß Anspruch 1, das die Schritte umfasst eines Bestimmens des Drain-Source-Stroms, $I_{ds}$, der durch den Transistor (5) fließt, und Bestimmen der Differential-Drain-Source-Spannung $V_{ds}$ über den Transistor.

**3.** Ein Verfahren gemäß Anspruch 2, wobei der Wert von $R_{dson}$ durch die Gleichung $R_{dson} = V_{ds}/I_{ds}$ bestimmt wird.

**4.** Ein Verfahren gemäß Ansprüchen 1, wobei der erwartete Wert $R_{dson}$ durch die Gleichung bestimmt wird:

$$R_{dsonexp} = R_{dsonTx} \left(1 + \alpha \left(T_{real} - T_x\right)\right)$$

wobei $R_{dsonTx}$ der Wert des Widerstands der Leistungsvorrichtung (5) bei einer Temperatur $T_x$ ist und $T_{real}$ die Temperatur der Vorrichtung ist.

**5.** Ein Verfahren gemäß Anspruch 4, wobei $T_x$ eine Umgebungstemperatur zwischen 15 und 35°C ist.

**6.** Ein Verfahren gemäß einem vorhergehenden Anspruch, das umfasst ein Bestimmen der Differenz zwischen dem tatsächlichen Widerstand $R_{dson}$ und dem erwarteten Widerstand $R_{dsonexp}$ als einen Anteil des erwarteten Widerstands und Bestimmen, dass es einen Fehler gibt, wenn dieser Anteil einen Schwellenwert übersteigt oder gleich diesem ist.

**7.** Ein Verfahren gemäß den Ansprüchen1 bis 6, das umfasst, wenn bestimmt wird, dass es einen Fehler gibt, Erzeugen einer Warnung oder Abschalten der Vorrichtung.

**8.** Ein Verfahren gemäß den Ansprüchen 1 bis 7, wobei die Halbleitervorrichtung (4) ein Teil eines Fahrzeugverwaltungssystems oder einer elektronischen Fahrzeugsteuereinheit (1) ist.

**9.** Ein Verfahren gemäß Anspruch 1 bis 8, wobei die Vorrichtung (4) eine Schaltvorrichtung, eine Leistungsvorrichtung, einer Treibervorrichtung oder eine Smartpower-Vorrichtung ist.

**10.** Ein Verfahren gemäß den Ansprüchen 1 bis 9, wobei der Transistor (5) ein MOSFET oder anderer Leistungstransistor ist.

**11.** Ein System, das ausgebildet ist zum Überwachen einer Halbleitervorrichtung (4), die einen Transistor (5) umfasst als Teil einer Leistungsvorrichtung, das Mittel aufweist zum Bestimmen des Widerstands $R_{dson}$ zwischen dem Drain und der Source des Transistors, wenn der Transistor in einem EIN-Zustand ist, und Mittel zum Vergleichen dieses Werts mit einem erwarteten Wert, $R_{dsonexp}$, um zu bestimmen, ob es einen Fehler gibt, und **gekennzeichnet durch** Mittel (11) aufweisend zum Schätzen oder Messen der Temperatur $T_{real}$ der Vorrichtung und Verwenden dieser zum Bestimmen eines erwarteten Werts $R_{dsonexp}$.

**12.** Ein System gemäß Anspruch 11, das die Mittel (10) umfasst zum Bestimmen des Drain-Source-Stroms, $I_{ds}$, der durch den Transistor fließt, und der Differential-Drain-Source-Spannung $V_{ds}$ über den Transistor.

**13.** Ein System gemäß Anspruch 11 oder 12, das Mittel umfasst zum Bestimmen des Werts von $R_{dson}$ aus der Gleichung $R_{dson} = V_{ds}/I_{ds}$.

**14.** Ein System gemäß Anspruch 11, das Mittel umfasst zum Bestimmen des erwarteten Werts aus der Gleichung:

$$R_{dsonexp} = R_{dsonTx} \left(1 + \alpha \left(T_{real} - T_x\right)\right)$$

wobei $R_{dsonTx}$ der Wert des Widerstands der Vorrichtung (4) bei einer eingestellten Temperatur $T_x$ ist und $T_{real}$ die gemessene Temperatur der Vorrichtung ist.

**15.** Ein System gemäß Anspruch 14, wobei $T_x$ eine Umgebungstemperatur zwischen 15 und 35°C ist.

**16.** Ein System gemäß den Ansprüchen 11 bis 15, das Mittel umfasst zum Bestimmen der Differenz zwischen dem tatsächlichen Widerstand $R_{dson}$ und dem erwarteten Widerstand $R_{dsonexp}$ als einen Anteil des erwarteten Widerstands und Mittel zum Bestimmen, dass es einen Fehler gibt, wenn dieser Anteil einen Schwellenwert übersteigt oder gleich diesem ist.

**17.** Ein System gemäß den Ansprüchen 11 bis 16, das Mittel umfasst zum Erzeugen einer Warnung oder Abschalten der Vorrichtung, wenn bestimmt wird, dass es einen Fehler gibt.

**18.** Ein System gemäß den Ansprüche 11 bis 17, wobei die Halbleitervorrichtung (4) ein Teil eines Fahrzeugverwaltungssystems oder einer elektronischen Fahrzeugsteuereinheit ist.

**19.** Ein System gemäß den Ansprüchen 11 bis 18, wobei die Vorrichtung (4) eine Schaltvorrichtung, eine Leistungsvorrichtung, einer Treibervorrichtung oder eine Smartpower-Vorrichtung ist.

**20.** Ein System gemäß den Ansprüchen 11 bis 19, wobei der Transistor (5) ein MOSFET oder anderer Leistungstransistor ist.

## Revendications

**1.** Procédé de surveillance d'un dispositif à semi-conducteur (4) qui comprend un transistor (5) faisant partie d'un dispositif de puissance, comprenant les étapes consistant à déterminer la résistance $R_{dson}$ entre le drain et la source du transistor (5) lorsque le transistor est dans un état actif, à comparer cette valeur à une valeur attendue $R_{dsonexp}$ et à déterminer qu'il y a un défaut en fonction du résultat de ladite comparaison, **caractérisé en ce que** la température $T_{real}$ du dispositif est mesurée ou estimée et utilisée pour déterminer une valeur de la valeur attendue $R_{dsonexp}$.

**2.** Procédé selon la revendication 1, comprenant les étapes consistant à déterminer le courant drain-source $I_{ds}$ s'écoulant à travers le transistor (5) et à déterminer la tension différentielle drain-source $V_{ds}$ aux bornes du transistor.

**3.** Procédé selon la revendication 2, selon lequel la valeur de $R_{dson}$ est déterminée par l'équation :

$$R_{dson} = V_{ds}/I_{ds}$$

**4.** Procédé selon la revendication 1, selon lequel ladite valeur attendue $R_{dsonexp}$ est déterminée par l'équation :

$$R_{dsonexp} = R_{dsonTx} \left(1 + \alpha \left(T_{real} - T_x\right)\right)$$

où $R_{dsonTx}$ est la valeur de la résistance du dispositif de puissance (5) à une température $T_x$ et $T_{real}$ est la température du dispositif.

**5.** Procédé selon la revendication 4, selon lequel $T_x$ est une température ambiante entre 15 et 35° C.

**6.** Procédé selon l'une quelconque des revendications précédentes, comprenant l'étape consistant à déterminer la différence entre la résistance réelle $R_{dson}$ et la résistance attendue $R_{dsonexp}$ en tant que proportion de la résistance attendue et à déterminer qu'il y a un défaut si cette proportion dépasse ou est égale à une valeur seuil.

**7.** Procédé selon les revendications 1 à 6, comprenant, si l'on a déterminé qu'il y a un défaut, l'étape consistant à générer une alerte ou à désactiver ledit dispositif.

**8.** Procédé selon les revendications 1 à 7, selon lequel ledit dispositif à semi-conducteur (4) fait partie d'un système de gestion de véhicule ou d'une unité de commande électronique de véhicule (1).

**9.** Procédé selon les revendications 1 à 8, selon lequel ledit dispositif (4) est un dispositif de commutation, un dispositif de puissance, un dispositif d'attaque ou un dispositif de puissance intelligent (ou Smartpower).

**10.** Procédé selon les revendications 1 à 9, selon lequel ledit transistor (5) est un MOSFET ou un autre transistor de puissance.

**11.** Système adapté pour surveiller un dispositif à semi-conducteur (4) qui comprend un transistor (5) faisant partie d'un dispositif de puissance, comprenant un moyen pour déterminer la résistance $R_{dson}$ entre le drain et la source du transistor lorsque le transistor est dans un état actif et un moyen pour comparer cette valeur à une valeur attendue $R_{dsonexp}$ pour déterminer s'il y a un défaut, **caractérisé en ce que** le système comprend un moyen (11) pour estimer ou mesurer la température $T_{real}$ du dispositif et utiliser celle-ci pour déterminer une valeur attendue $R_{dsonexp}$.

**12.** Système selon la revendication 11, comprenant un moyen (10) pour déterminer le courant drain-source $I_{ds}$ s'écoulant à travers le transistor et la tension différentielle drain-source $V_{ds}$ aux bornes du transistor.

**13.** Système selon les revendications 11 ou 12, comprenant un moyen pour déterminer la valeur de $R_{dson}$ à partir de l'équation $R_{dson} = V_{ds}/I_{ds}$.

**14.** Système selon la revendication 11, comprenant un moyen pour déterminer ladite valeur attendue à partir de l'équation :

$$R_{dsonexp} = R_{dsonTx} \left(1 + \alpha(T_{real} - T_x)\right)$$

où $R_{dsonTx}$ est la valeur de la résistance du dispositif (4) à une température définie $T_x$ et $T_{real}$ est la température mesurée du dispositif.

**15.** Système selon la revendication 14, dans lequel $T_x$ est une température ambiante entre 15 et 35° C.

**16.** Système selon les revendications 11 à 15, comprenant un moyen pour déterminer la différence entre la résistance réelle $R_{dson}$ et la résistance attendue $R_{dsonexp}$ en tant que proportion de la résistance attendue et un moyen pour déterminer qu'il y a un défaut si cette proportion dépasse ou est égale à une valeur seuil.

**17.** Système selon les revendications 11 à 16, comprenant un moyen pour générer une alerte ou désactiver ledit dispositif si l'on a déterminé qu'il y a un défaut.

**18.** Système selon les revendications 11 à 17, dans lequel le dispositif à semi-conducteur (4) fait partie d'un système de gestion de véhicule ou d'une unité de commande électronique de véhicule.

**19.** Système selon l'une quelconque des revendications 11 à 18, dans lequel ledit dispositif (4) est un dispositif de commutation, un dispositif de puissance, un dispositif d'attaque ou un dispositif de puissance intelligent (ou Smartpower).

**20.** Système selon l'une quelconque des revendications 11 à 19, dans lequel le transistor (5) est un MOSFET ou un autre transistor de puissance.

Fig 1

**EP 2 760 093 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4896245 A
- US 2005088863 A
- US 7113019 B
- US 20050237689 A